(19) **Europäisches Patentamt / European Patent Office / Office européen des brevets**

(11) **EP 3 971 133 B1**

(12) **FASCICULE DE BREVET EUROPEEN**

(45) Date de publication et mention de la délivrance du brevet:
**22.03.2023 Bulletin 2023/12**

(21) Numéro de dépôt: **21196249.3**

(22) Date de dépôt: **13.09.2021**

(51) Classification Internationale des Brevets (IPC):
**B81C 1/00** $^{(2006.01)}$ **B29C 65/44** $^{(2006.01)}$
**B29C 65/64** $^{(2006.01)}$ **B29C 65/00** $^{(2006.01)}$
**B01L 3/00** $^{(2006.01)}$

(52) Classification Coopérative des Brevets (CPC):
(C-Sets disponibles)
**B81C 1/00238; B29C 65/44; B29C 65/64; B29C 66/1122; B29C 66/30321; B29C 66/53461; B29C 66/54; B29C 66/744; B29C 66/7465; B29C 66/8322; B29C 66/91943;** B01L 3/502707; B01L 2300/0887; B29C 65/645; B29C 66/71;

(Cont.)

(54) **PROCÉDÉ DE FABRICATION D'UN DISPOSITIF MICRO-FLUIDIQUE ET DISPOSITIF FABRIQUÉ PAR LEDIT PROCÉDÉ**

VERFAHREN ZUR HERSTELLUNG EINER MIKROFLUIDISCHEN VORRICHTUNG UND MIT DIESEM VERFAHREN ERHALTENE VORRICHTUNG

METHOD FOR MANUFACTURING A MICROFLUIDIC DEVICE AND DEVICE MANUFACTURED USING SAID METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.09.2020 FR 2009399**

(43) Date de publication de la demande:
**23.03.2022 Bulletin 2022/12**

(73) Titulaire: **Commissariat à l'énergie atomique et aux énergies alternatives 75015 Paris (FR)**

(72) Inventeurs:
• **CONSTANTIN, Olivier 38054 Grenoble Cedex 09 (FR)**
• **BALERAS, François 38054 Grenoble Cedex 09 (FR)**
• **FRESNEAU, Thibault 38054 Grenoble Cedex 09 (FR)**
• **VERPLANCK, Nicolas 38054 Grenoble Cedex 09 (FR)**

(74) Mandataire: **INNOV-GROUP 310, avenue Berthelot 69372 Lyon Cedex 08 (FR)**

(56) Documents cités:
WO-A1-2011/042422    DE-A1-102010 031 103
DE-A1-102011 076 693    DE-A1-102016 226 198
US-A1- 2019 070 606

(52) Classification Coopérative des Brevets (CPC):
(Cont.)
B29C 66/73117; B29L 2031/34; B29L 2031/756;
B81B 2201/058; B81C 2203/037

C-Sets
B29C 66/71, B29K 2023/38;
B29C 66/71, B29K 2033/12

## Description

## Domaine technique de l'invention

La présente invention se rapporte à un procédé de fabrication d'un dispositif micro-fluidique et au dispositif micro-fluidique obtenu par le procédé.

## Etat de la technique

La micro-fluidique présente de plus en plus d'applications. L'une d'elles concerne notamment les laboratoires sur puce ("lab on chip") ainsi que les microsystèmes d'analyse autonomes. Ces applications peuvent nécessiter l'intégration de capteurs ou d'imageurs au sein d'un substrat micro-fluidique, afin de surveiller en temps réel et au plus près l'échantillon présent dans le substrat. Cependant, les capteurs sont souvent réalisés dans des technologies différentes de celles employées pour le substrat et pas toujours compatibles. Il faut en effet s'assurer que la technologie pour hybrider capteurs et substrat produise des systèmes qui soient étanches, fermés, fonctionnels sur l'aspect fluidique et électrique, faciles à relier avec l'extérieur pour les arrivées de fluide et les reprises de contacts électriques, et enfin biocompatibles.

Actuellement les dispositifs sont souvent composés d'un substrat micro-fluidique, réalisé sous la forme d'une carte, et d'un composant réalisé sur substrat silicium ou verre et portant une fonctionnalité particulière. Le composant est souvent fixé au substrat par collage, ce qui peut s'avérer incompatible avec le processus fluidique (présence de solvant, adsorption parasite de molécules biologiques, absence de biocompatibilité...) ou former des volumes morts gênants. D'autres méthodes d'intégration micro-fluidique de composants ont été décrites dans l'état de la technique. A titre d'exemple, le composant peut aussi être fixé par effet magnétique mais cela nécessite l'apport de joints d'étanchéité, dont la mise en place n'est pas aisée et ne garantit pas une étanchéité au cours du temps.

Enfin, les techniques connues ne permettent souvent pas d'obtenir une cadence de fabrication élevée.

La demande de brevet WO2011/042422A1 décrit une méthode d'assemblage entre deux éléments microfluidiques.

Le document DE102016226198A1 décrit pour sa part une solution d'assemblage d'un composant portant des plots d'ancrage sur un substrat.

Le but de l'invention est de disposer d'une solution qui permette d'assembler un composant sur un substrat micro-fluidique en vue d'obtenir une étanchéité fluidique et éventuellement une reprise électrique entre ces deux parties et qui soit :

- Simple à mettre en oeuvre ;
- D'un coût modéré ;
- Qui ne nécessite pas d'apport de matière de type colle, solvants, ni d'éléments supplémentaires de type joints ;
- Possible d'être fabriquée à une cadence élevée ;
- Qui permette un transfert industriel facile, par l'emploi de techniques existantes ;

## Exposé de l'invention

Ce but est atteint par un procédé de fabrication d'un dispositif micro-fluidique, ledit dispositif comprenant un substrat en polymère thermoplastique présentant une face dite supérieure et un premier circuit micro-fluidique qui comporte au moins une ouverture débouchant sur ladite face supérieure, et un composant portant des plots (agencés pour venir s'ancrer dans ledit substrat en périphérie de ladite ouverture, ledit procédé comportant les étapes suivantes :

- Chauffage pour que les plots d'ancrage du composant atteignent une température au moins égale à la température de transition vitreuse du substrat ;
- Fixation du composant sur le substrat par enfoncement puis ancrage de ses plots dans le substrat ;

Selon une particularité, le procédé comporte une étape préalable de création de trous sur le substrat, configurés chacun pour recevoir un plot distinct du composant, en vue de faciliter l'enfoncement de chaque plot du composant lors de l'étape de fixation.

L'invention concerne également un dispositif micro-fluidique comprenant un substrat en polymère thermoplastique présentant une face dite supérieure et un premier circuit micro-fluidique qui comporte au moins une ouverture débouchant sur ladite face supérieure, et un composant portant des plots agencés pour venir s'ancrer dans ledit substrat en périphérie de ladite ouverture, ledit dispositif étant obtenu par le procédé de fabrication tel que défini ci-dessus.

Selon une particularité, le substrat est réalisé en copolymère cyclo-oléfine.

Selon une autre particularité, le composant est réalisé sur substrat silicium ou verre.

Selon une autre particularité, les plots d'ancrage comportent au moins un premier plot réalisé au moins partiellement en matériau métallique.

Selin une variante de réalisation, le substrat comporte un premier circuit électrique et le composant comporte un deuxième circuit électrique, ledit premier plot est configuré pour assurer une connexion électrique entre le premier circuit électrique et le deuxième circuit électrique.

Selon une particularité, le matériau métallique est composé de cuivre ou d'un alliage de type SnAg.

Selon une autre particularité, les plots d'ancrage comportent un ou plusieurs plots d'ancrage réalisés en silicium.

Selon une autre particularité, les plots d'ancrage présentent à leur extrémité libre un dôme arrondi ou une face plane.

Selon une réalisation particulière, le substrat comporte des trous configurés chacun pour recevoir un plot distinct du composant, lesdits trous étant réalisés en vue de faciliter l'enfoncement de chaque plot du composant.

Selon une particularité, le composant est appliqué par une face, dite face inférieure, contre la face supérieure du substrat et scellé sur le substrat par l'intermédiaire desdits plots d'ancrage, et le composant est scellé pour fermer l'ouverture du premier circuit fluidique de manière étanche, sur la face supérieure du substrat.

Selon une réalisation particulière, l'ouverture du premier circuit fluidique présente une forme de canal fermée sur sa paroi supérieure par la face inférieure dudit composant.

Selon une autre réalisation particulière, le composant comporte un deuxième circuit micro-fluidique, ledit composant étant positionné sur le substrat pour assurer une liaison fluidique étanche entre le premier circuit micro-fluidique du substrat et le deuxième circuit micro-fluidique du composant.

Selon une particularité, le deuxième circuit micro-fluidique du composant comporte un canal micro-fluidique configuré pour assurer une liaison étanche entre deux ouvertures du premier circuit fluidique.

Selon une autre particularité, le composant comporte également au moins une rangée de plots agencés pour s'ancrer dans ledit substrat et disposés pour former un cordon périphérique pour consolider l'assemblage du composant sur le substrat.

## Brève description des figures

D'autres caractéristiques et avantages vont apparaître dans la description détaillée qui suit faite en regard des dessins annexés dans lesquels :

- La figure 1 montre les différentes étapes du procédé de fabrication d'un dispositif micro-fluidique, selon l'invention ; chaque étape est illustrée par une vue en perspective et une vue en coupe.
- Les figures 2A, 2B, 2C, 2D, 2E représentent, vues en coupe transversale, plusieurs variantes de réalisation d'un dispositif micro-fluidique pouvant être obtenu par le procédé de l'invention.
- La figure 3 représente plusieurs variantes de réalisation des plots d'ancrage du composant.
- Les figure 4A et 4B représentent, en vue de dessus, deux variantes de réalisation de l'ouverture fluidique qui est présente sur le substrat.
- La figure 5 représente, vue en coupe transversale, plusieurs configurations pour lesquelles le composant est fixé sur le substrat.
- La figure 6 montre plusieurs architectures du composant et illustrent les différents paramètres qu'il est possible d'ajuster sur le composant pour répondre aux différentes configurations représentées sur la figure 5.

## Description détaillée d'au moins un mode de réalisation

Dans la suite de la description, les termes 'haut", "bas", "inférieur" et "supérieur" sont à comprendre en prenant comme référence un axe (X) tracé verticalement sur la feuille.

L'invention vise notamment un procédé de fabrication d'un dispositif micro-fluidique qui comporte uniquement un substrat 1 micro-fluidique et un composant 2 destiné à être fixé sur le substrat. Le composant peut avoir différentes caractéristiques et fonctions (passives (filtre physique) ou actives (capteur, actionneur)).

L'assemblage du composant sur le substrat est réalisé de manière étanche sans l'emploi de matériaux de type colle, solvant, ni d'éléments supplémentaires.

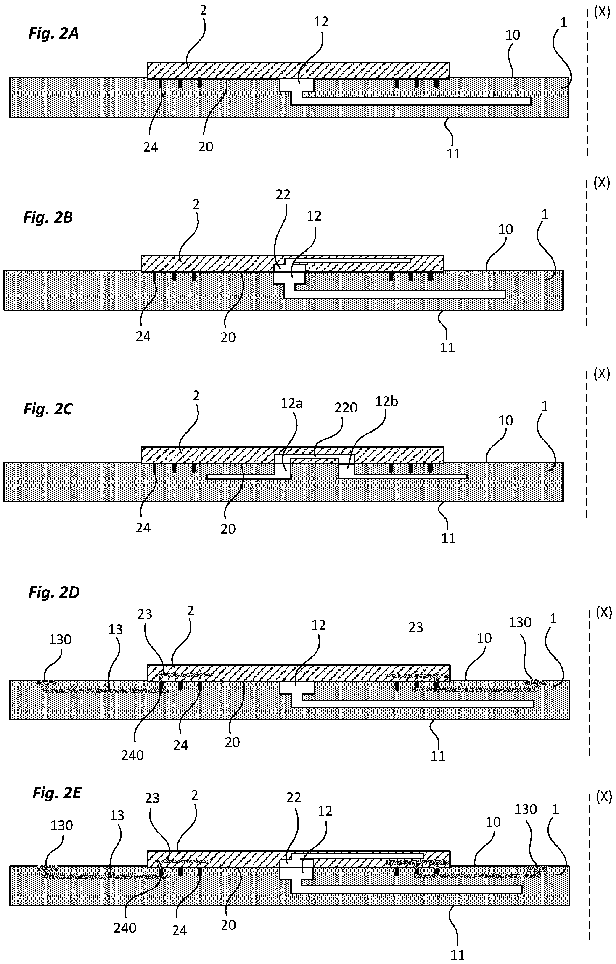

Les figures 2A à 2E montrent différentes variantes de réalisation du dispositif micro-fluidique obtenu.

Le substrat 1 peut être réalisé en un matériau polymère thermoplastique. A titre d'exemple, il peut s'agir d'un matériau tel que le COC ("Copolymère Cyclo-Oléfine") ou PMMA ("Polyméthacrylate de méthyle").

Le substrat 1 peut se présenter sous la forme d'une carte présentant une face supérieure 10 et une face inférieure 11 opposée.

Le substrat 1 comporte un premier circuit micro-fluidique. Ce premier circuit micro-fluidique peut être de tous types. A titre d'exemple, il peut comporter une ou plusieurs cavités et des canaux micro-fluidiques. Il comporte au moins une ouverture 12 débouchant sur une face du substrat, par exemple sur sa face supérieure 10.

Le substrat 1 peut également comporter, en plus du premier circuit micro-fluidique, un premier circuit électrique comprenant une ou plusieurs pistes électriques 13 et un ou plusieurs points de connexion électrique 130 (figures 2D et 2E) permettant de connecter le premier circuit électrique à un système externe.

Le composant 2 à fixer sur le substrat 1 peut être réalisé majoritairement sur substrat silicium ou verre.

Il est destiné à venir se fixer sur une face du substrat, par exemple sur sa face supérieure 10.

Le composant 2 présente avantageusement une forme au moins dotée d'une face plane, dite face inférieure 20, destinée à venir en appui contre la face correspondante du substrat, par exemple la face supérieure 10.

Le composant 2 peut être destiné à obturer le premier circuit micro-fluidique du substrat, au moins son ouverture 12, de manière étanche.

Le composant 2 peut comporter un deuxième circuit micro-fluidique, pouvant comporter par exemple une ouverture 22 débouchant sur sa face inférieure 20 et des canaux. Le composant 2 peut alors être fixé sur le substrat pour réaliser une connexion fluidique étanche entre le premier circuit micro-fluidique du substrat et le deuxième circuit micro-fluidique du composant (figures 2B, 2C et 2E). Sur la figure 2B, le circuit micro-fluidique du composant 2 peut comporter un canal 220 agencé pour réaliser une jonction fluidique ou pontage entre deux points fluidiques 12a, 12b du circuit micro-fluidique du substrat 1.

Le composant 2 peut comporter un deuxième circuit électrique (figures 2D et 2E), destiné à se connecter au premier circuit électrique du substrat. Ce deuxième circuit électrique peut comporter une ou plusieurs pistes électriques 23.

Il faut comprendre que toutes les combinaisons sont bien entendu réalisables, que ce soit au niveau de la présence de circuits micro-fluidiques au niveau du composant et/ou au niveau du substrat et de la présence de circuits électriques au niveau du composant et*ou au niveau du substrat.

Pour se fixer au substrat 1, le composant 2 comporte plusieurs plots 24 lui permettant de s'ancrer dans le substrat 1.

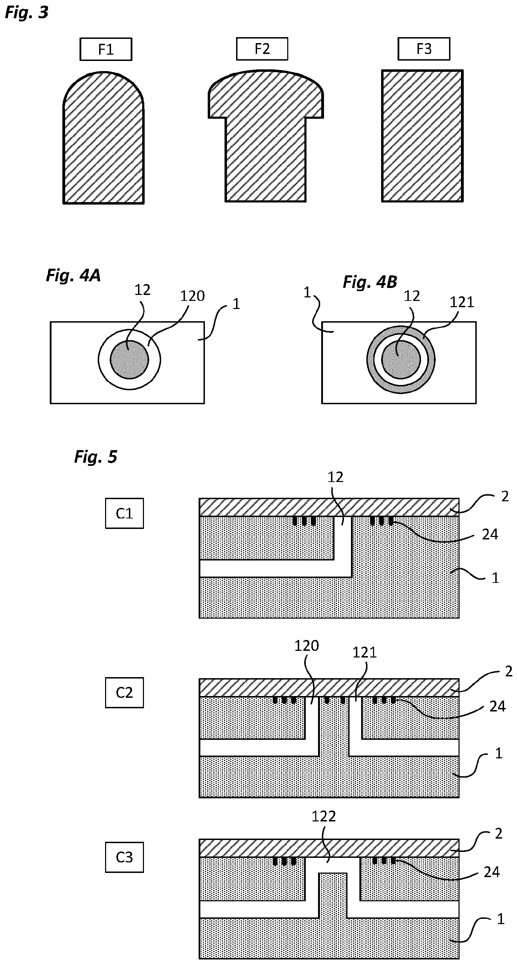

De manière non limitative, en référence à la figure 3, les plots 24 peuvent présenter une forme en obus (F1), en champignon (F2) ou en forme de piliers cylindriques (F3).

Les plots peuvent être de différentes natures. Il peut s'agir de plots 24 en silicium formés par gravure et technique de type "under etching" d'un socle de silice ou par une succession de gravures anisotropes et isotropes, de micro-piliers obtenus par gravure profonde, ou encore de plots métalliques de type "micro-bumps" (voir ci-dessous).

La taille et la forme des plots 24 peuvent être optimisées pour assurer la fixation du composant 2 et son maintien sur le substrat 1, en garantissant au moins une étanchéité du circuit fluidique entre le substrat 1 et le composant 2.

De manière non limitative, les plots 24 peuvent présenter une hauteur comprise entre 20 et 40$\mu$m, un diamètre compris entre 20 et 50$\mu$m.

Les plots 24 peuvent être organisés selon différentes configurations, pour tenir compte de l'architecture du circuit micro-fluidique du substrat. Dans le cas d'une ouverture circulaire à fermer par le dessus ou à connecter, les plots peuvent être organisés en plusieurs anneaux concentriques. Ils peuvent aussi être organisés en plusieurs rangées (lignes ou colonnes) et suivre le contour de la zone micro-fluidique à considérer. D'une rangée à une autre, les plots 24 peuvent être alignés ou organisés en quinconce.

Ils peuvent être espacés d'une distance comprise entre 20 et 50$\mu$m, au sein de chaque rangée et/ou d'une rangée à une autre.

Une ou plusieurs rangées de plots 24 pourront être disposées en d'autres endroits pour consolider l'assemblage entre le substrat 1 et le composant 2.

Au moins l'un des plots (référencé 240 sur les figures) peut également comporter au moins une partie réalisée dans un matériau métallique, conducteur de l'électricité, formant un point de connexion électrique du circuit électrique du composant évoqué ci-dessus, si celui-ci est présent. Plusieurs plots 240 de ce type peuvent être présents et judicieusement positionnés. Chaque plot 240 peut avantageusement être réalisé en totalité en matériau métallique, par exemple réalisé sous la forme de "micro-bump". Le matériau conducteur de l'électricité employé dans chacun de ces plots 240 peut être le cuivre ou un alliage de type Sn/Ag.

Par chacun de ces plots 240, le circuit électrique du composant peut se connecter au circuit électrique du substrat 1. Une piste électrique peut permettre de connecter la partie métallique du plot au circuit électrique du composant pour effectuer une reprise de contact.

Au niveau du substrat 1, pour chaque point de connexion électrique, un trou peut être aménagé dans une piste conductrice du circuit électrique du substrat afin d'accueillir ou à tout le moins de faciliter l'insertion du plot de connexion correspondant du composant.

Il faut noter que ces plots 240 de connexion électrique sont ancrés dans le substrat 1 de manière similaire aux autres plots 24 du composant 2.

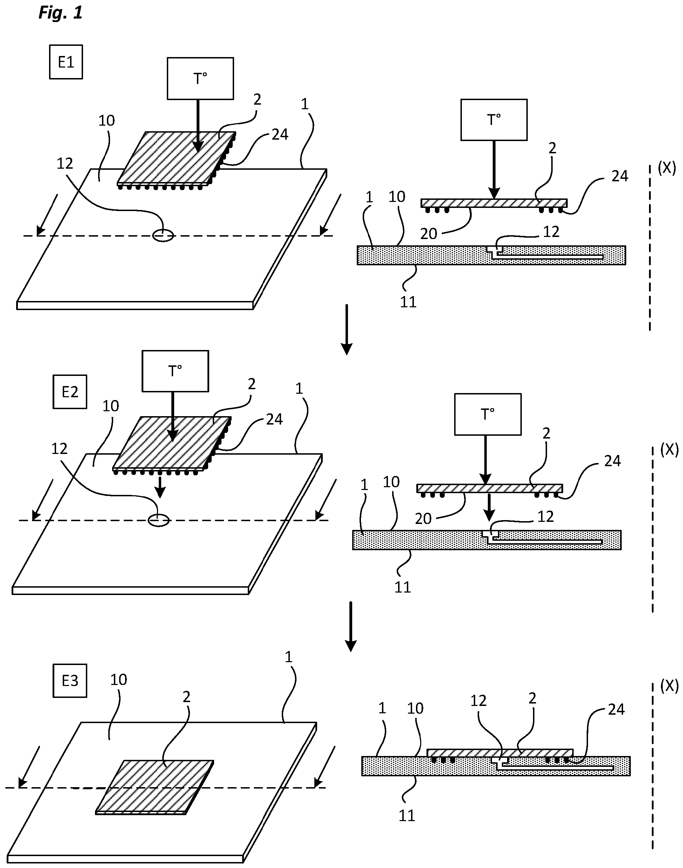

Partant d'un substrat tel que décrit ci-dessus et d'un composant à assembler sur ledit substrat, la figure 1 montre les différentes étapes de fabrication (E1 à E3) du dispositif :

**E1** : Il s'agit d'une étape de chauffage (T°) permettant de chauffer les plots 24 du composant 2, pour que ceux-ci atteignent une température au moins égale à la température de transition vitreuse (couramment appelée température Tg) du polymère thermoplastique qui compose le substrat 1. A titre d'exemple, pour un substrat à base de COC 5013, la température Tg est égale à 134°C. La température à laquelle les plots sont chauffés ne doit pas non plus être trop élevée, pour éviter toute détérioration du substrat et de son circuit micro-fluidique.

Le chauffage peut être réalisé de différentes manières. A titre d'exemple, on peut employer un équipement classiquement utilisé pour le montage en surface de composants électroniques. Ce type d'équipement peut notamment permettre de ne chauffer que le composant à assembler. Il a également l'avantage d'être communément utilisé dans l'industrie, facilitant d'autant le transfert technologique du procédé.

Préalablement, des trous peuvent être préformés dans le substrat 1 aux emplacements destinés à recevoir les plots 24, afin de faciliter l'enfoncement des plots 24 dans le substrat 1.

**E2** : Il s'agit de l'étape de fixation du composant sur le substrat. La fixation est réalisée en appliquant la face inférieure 20 du composant 2 contre la face supérieure 10 du substrat 1.

Grâce au chauffage des plots 24 à la température au moins égale à la température de transition vitreuse du substrat 1, le composant est comprimé contre le substrat 1, sa face inférieure 20 contre la face supérieure 10 du substrat 1, de sorte que ses plots 24 s'enfoncent dans la matière du substrat. Le polymère formant le substrat fondant localement, il vient englober les plots et les emprisonner en refroidissant, assurant l'ancrage du composant 2 dans le substrat 1 et son maintien sur le substrat 1. Il faut noter qu'un chauffage (T°) peut être maintenu lors de cette étape E2 afin de garder les plots à la température adaptée (supérieure à Tg) et de faciliter leur pénétration dans le substrat 1 lors de l'appui du composant 2 contre le substrat. Le chauffage peut être mis en oeuvre de manière identique à celui décrit pour l'étape E1.

Ce principe de fixation du composant sur le substrat permet de réaliser une liaison étanche dans le plan de jonction entre le composant et le substrat, que ce soit pour venir obturer au moins une ouverture 12 du premier circuit-micro-fluidique du substrat, ou pour assurer une connexion fluidique étanche entre le premier circuit micro-fluidique du substrat 1 et le deuxième circuit micro-fluidique du composant 2. Cette liaison est réalisée sans apport de matière ou d'éléments supplémentaires.

Il faut noter qu'il est également possible d'assister le scellement thermo-compressif par l'apport d'ultrasons, afin d'accélérer le placement du composant sur le substrat et/ou de réduire l'apport de chaleur lors de l'étape de chauffage. Dans tous les cas, il s'agit de faire en sorte que les plots 24 atteignent une température au moins égale à la température de transition vitreuse du polymère thermoplastique formant le substrat.

Dans le cas de réalisation d'une connexion fluidique étanche entre le premier circuit micro-fluidique du substrat 1 et le deuxième circuit micro-fluidique du composant 2, l'idéal pour optimiser la résistance hydrodynamique est d'avoir un rayon de canal fluidique identique dans le substrat 1 et le composant 2. Cependant, il peut s'avérer nécessaire de limiter le fluage de matière se produisant lors du scellement du composant 2 sur le substrat 1, ce fluage pouvant en effet venir boucher l'ouverture fluidique 12. Pour éviter cela, comme illustré par les figures 4A et 4B, du côté substrat, un chanfrein 120 peut être réalisé au niveau de l'ouverture (figure 4A), ou autour de cette ouverture, par création d'un canal concentrique 121 (Figure 4B), avec des dimensions adaptées. Pour un chanfrein 120, ces dimensions peuvent être définies par la relation suivante :

$$Vd = \pi \times x^2/2 \times \tan(y) \times (2r + x \times \tan(y))$$

Dans laquelle :

- x correspond à la hauteur (en $\mu$m) du chanfrein à réaliser ;
- y correspond à l'angle (en degrés) du chanfrein ;
- Vd correspond au volume de polymère du substrat amené à fluer lors du scellement et donc à retirer grâce à la présence du chanfrein (soit au volume de l'ensemble des plots 24 entourant l'ouverture 12)
- r correspond au rayon du canal fluidique ;

En variante du chanfrein, il est possible d'envisager la création d'une dépouille droite au niveau de l'ouverture 12, voire d'une dépouille à l'extérieur d'une couronne de plots 24 entourant l'ouverture.

E3 : la fixation du composant sur le substrat est finalisée. Il faut noter que l'étanchéité est obtenue, sans apport de moyens d'étanchéité de type joint, ni apport de matière de type colle, solvant ou équivalent.

Différents essais ont été menés pour valider le procédé de fabrication de l'invention.

Pour tenir compte des caractéristiques du circuit micro-fluidique du substrat, différents paramètres peuvent être ajustés au niveau du composant :

- Le nombre de rangées de plots (autour de l'ouverture du circuit pour assurer l'étanchéité et sur le pourtour du composant pour sa tenue mécanique sur le substrat) : Par exemple 5 à 10 rangées ;
- L'arrangement des plots d'une rangée à une autre (alignés ou en quinconce) ;
- La distance d'éloignement des rangées de plots par rapport à l'ouverture, par exemple comprise entre 100$\mu$m et 200$\mu$m ;

En référence à la figure 5, des essais ont été menés pour des substrats disposant chacun d'un circuit micro-fluidique prenant l'une des trois configurations suivantes :

- Une ouverture 12 de section circulaire débouchant sur la face supérieure du substrat (configuration C1) ;
- Deux ouvertures 120, 121 de section circulaire, débouchant chacune de manière indépendante sur la face supérieure du substrat (configuration C2) ;
- Un canal 122 creusé sur la face supérieure du substrat et formant une empreinte sur cette face (configuration C3) ;

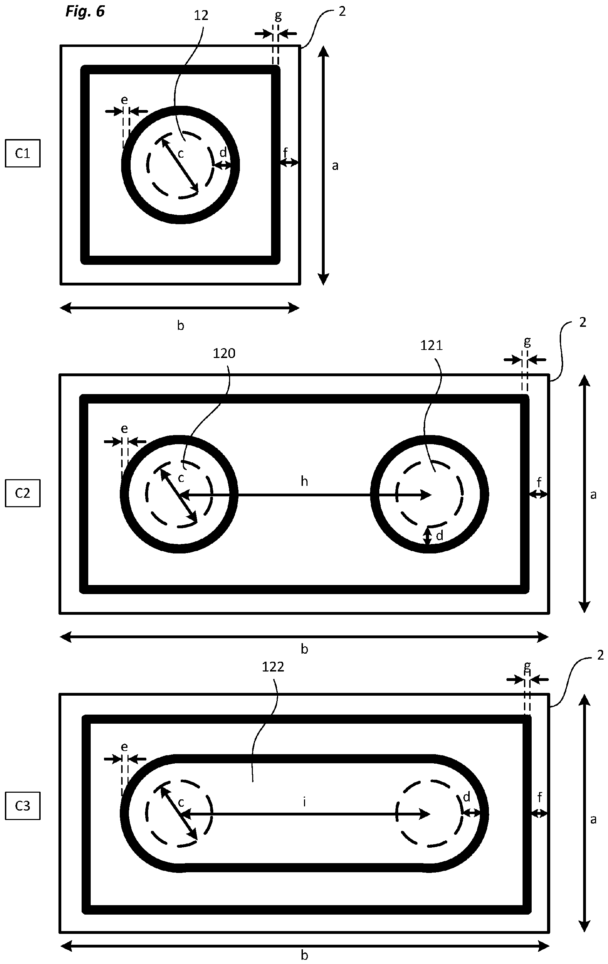

Partant de ces différentes configurations de substrat, la figure 6 illustre les différents paramètres qu'il est possible d'ajuster pour assurer un scellement étanche sur le substrat considéré (configuration C1, C2 ou C3).

Dans ces configurations, on peut voir ainsi les paramètres d'ajustement suivants :

(a) Largeur du composant,
(b) Longueur du composant,
(c) Diamètre de l'ouverture fluidique à sceller, prévue sur le substrat,
(d) Espacement entre les plots réalisés sur le composant et l'emplacement de l'ouverture réalisée sur le substrat,
(e) Largeur de la bande des plots présents sur le composant (dépend de l'espacement d, du diamètre et du nombre de plots) disposés en couronne sur le pourtour de l'ouverture fluidique,
(f) Espacement entre le bord du composant et la couronne de plots,

(g) Largeur de la bande de plots utilisés sur la couronne de tenue mécanique,

(h) Espacement entre deux ouvertures fluidiques (dans le cas des configurations C2 et C3),

(i) Longueur du canal fluidique (dans le cas de la configuration C3).

Selon la configuration C1, C2 ou C3, le composant est de forme carrée, de dimensions 4x4mm ou rectangle de dimensions 4x8.35mm.

En fonction de ces paramètres d'ajustement, plusieurs architectures de composant peuvent être proposées pour permettre un scellement étanche du composant sur le substrat, pour les différentes configurations (C1 à C3) du substrat.

Il faut noter que ces paramètres d'ajustement sont à prendre en compte, quelle que soit la configuration du circuit micro-fluidique du substrat.

L'étanchéité a ensuite été constatée pour différentes architectures substrat+composant, en injectant un fluide dans le circuit micro-fluidique du substrat à une pression donnée (au moins jusqu'à 1 Bar).

Il faut également noter que l'adjonction des fonctions électriques reste compatible avec les différentes réalisations. Dans ce cas, un ou plusieurs plots 240 du composant comportent au moins une partie conductrice chargée de se connecter électriquement sur un point de connexion électrique du substrat et assurer la liaison électrique entre le circuit électrique du substrat et un circuit électrique du composant.

On comprend de ce qui précède que l'invention présente de nombreux avantages, parmi lesquels :

- Une fabrication facile et rapide, pouvant utiliser des équipements déjà existants ;
- Une solution qui permet d'obtenir une connexion fluidique étanche entre le substrat et le composant, sans apport de matériau ou matière ;
- Une solution qui permet aussi de gérer des connexions électriques entre deux circuits ;
- Une solution qui permet de réduire le nombre total d'étapes d'hybridation ;
- Une gestion simultanée d'un grand nombre de capillaires et/ou de contacts électriques (haute densité) ;
- Une solution d'hybridation irréversible ;
- Une solution qui permet de simplifier les composants hybridés au substrat 1 en intégrant la fluidique dans ce seul substrat 1 (configuration C3 ci-dessus) ;

## Revendications

1. Procédé de fabrication d'un dispositif micro-fluidique, ledit dispositif comprenant un substrat (1) en polymère thermoplastique présentant une face dite supérieure (10) et un premier circuit micro-fluidique qui comporte au moins une ouverture (12, 122) débouchant sur ladite face supérieure (10), et un composant (2) portant des plots (24) agencés pour venir s'ancrer dans ledit substrat (1) en périphérie de ladite ouverture (12, 122), ledit procédé étant **caractérisé en ce qu'**il comporte les étapes suivantes :

   - Chauffage pour que les plots d'ancrage (24) du composant (2) atteignent une température au moins égale à la température de transition vitreuse du substrat (1) ;
   - Fixation du composant sur le substrat (1) par enfoncement puis ancrage de ses plots (24) dans le substrat (1) ;

2. Procédé selon la revendication 1, **caractérisé en ce qu'**il comporte une étape préalable de création de trous sur le substrat (1), configurés chacun pour recevoir un plot d'ancrage distinct du composant (2), en vue de faciliter l'enfoncement de chaque plot d'ancrage (24) du composant lors de l'étape de fixation.

3. Dispositif micro-fluidique comprenant un substrat (1) en polymère thermoplastique présentant une face dite supérieure (10) et un premier circuit micro-fluidique qui comporte au moins une ouverture (12, 122) débouchant sur ladite face supérieure (10), et un composant (2) portant des plots (24) agencés pour venir s'ancrer dans ledit substrat (1) en périphérie de ladite ouverture (12, 122), **caractérisé en ce qu'**il est obtenu par le procédé de fabrication tel que défini dans l'une des revendications précédentes.

4. Dispositif selon la revendication 3, **caractérisé en ce que** le substrat (1) est réalisé en copolymère cyclo-oléfine.

5. Dispositif selon la revendication 3 ou 4, **caractérisé en ce que** le composant (2) est réalisé sur substrat silicium ou verre.

6. Dispositif selon la revendication 5, **caractérisé en ce que**, les plots d'ancrage comportent au moins un premier plot d'ancrage (240) réalisé au moins partiellement en matériau métallique.

7. Dispositif selon la revendication 6, **caractérisé en ce que** le substrat (1) comporte un premier circuit électrique et **en ce que** le composant comporte un deuxième circuit électrique, ledit premier plot d'ancrage (240) est configuré pour assurer une connexion électrique entre le premier circuit électrique et le deuxième circuit électrique.

8. Dispositif selon la revendication 6 ou 7, **caractérisé en ce que** le matériau métallique est composé de cuivre ou d'un alliage de type SnAg.

**9.** Dispositif selon l'une des revendications 5 à 8, **caractérisé en ce que** les plots d'ancrage (24) comportent un ou plusieurs plots d'ancrage réalisés en silicium.

**10.** Dispositif selon l'une des revendications 3 à 9, **caractérisé en ce que** les plots d'ancrage (24) présentent à leur extrémité libre un dôme arrondi ou une face plane.

**11.** Dispositif selon l'une des revendications 3 à 10, **caractérisé en ce que** le substrat comporte des trous configurés chacun pour recevoir un plot d'ancrage (24) distinct du composant (2), lesdits trous étant réalisés en vue de faciliter l'enfoncement de chaque plot d'ancrage (24) du composant.

**12.** Dispositif selon l'une des revendications 3 à 11, **caractérisé en ce que** le composant (2) est appliqué par une face, dite face inférieure, contre la face supérieure du substrat et scellé sur le substrat (1) par l'intermédiaire desdits plots d'ancrage (24), et **en ce que** le composant est scellé pour fermer l'ouverture (12, 122) du premier circuit fluidique de manière étanche, sur la face supérieure du substrat.

**13.** Dispositif selon la revendication 12, **caractérisé en ce que** l'ouverture (122) du premier circuit fluidique présente une forme de canal fermée sur sa paroi supérieure par la face inférieure dudit composant.

**14.** Dispositif selon l'une des revendications 3 à 11, **caractérisé en ce que** le composant (2) comporte un deuxième circuit micro-fluidique et **en ce que** ledit composant (2) est positionné sur le substrat (1) pour assurer une liaison fluidique étanche entre le premier circuit micro-fluidique du substrat (1) et le deuxième circuit micro-fluidique du composant (2).

**15.** Dispositif selon la revendication 14, **caractérisé en ce que** le deuxième circuit micro-fluidique du composant (2) comporte au moins un canal micro-fluidique agencé pour assurer une liaison fluidique étanche entre deux ouvertures (12) du premier circuit fluidique.

**16.** Dispositif selon l'une des revendications 3 à 15, **caractérisé en ce que** le composant (2) comporte également au moins une rangée de plots d'ancrage (24) agencés pour s'ancrer dans ledit substrat et disposés pour former un cordon périphérique pour consolider l'assemblage du composant (2) sur le substrat (1).

**Patentansprüche**

**1.** Verfahren zur Herstellung einer mikrofluidischen Vorrichtung, wobei die Vorrichtung ein Substrat (1) aus thermoplastischem Polymer umfasst, das eine sogenannte obere Seite (10) und einen ersten mikrofluidischen Kreislauf aufweist, der zumindest eine Öffnung (12, 122) aufweist, die in die obere Seite (10) mündet, und ein Bauteil (2), das Stifte (24) trägt, die so angeordnet sind, dass sie sich im Substrat (1) am Umfang der Öffnung (12, 122) verankern, wobei das Verfahren **dadurch gekennzeichnet ist, dass** es die folgenden Schritte umfasst:

- Erhitzen, sodass die Verankerungsnoppen (24) des Bauteils (2) eine Temperatur erreichen, die mindestens der Glasübergangstemperatur des Substrats (1) entspricht;
- Befestigen des Bauteils am Substrat (1) durch Eindrücken und anschließendes Verankern seiner Stifte (24) im Substrat (1).

**2.** Verfahren nach Anspruch 1, **dadurch gekennzeichnet, dass** es einen vorherigen Schritt des Herstellens von Löchern im Substrat (1) umfasst, die jeweils dazu ausgelegt sind, einen einzelnen Verankerungsstift des Bauteils (2) aufzunehmen, um das Eindrücken jedes Verankerungsstifts (24) des Bauteils während des Befestigungsschritts zu ermöglichen.

**3.** Mikrofluidische Vorrichtung, umfassend ein Substrat (1) aus thermoplastischem Polymer, das eine sogenannte obere Fläche (10) und einen ersten mikrofluidischen Kreislauf aufweist, der zumindest eine Öffnung (12, 122) aufweist, die in die obere Seite (10) mündet, und ein Bauteil (2), das Stifte (24) trägt, die so angeordnet sind, dass sie sich im Substrat (1) am Umfang der Öffnung (12, 122) verankern, **dadurch gekennzeichnet, dass** sie durch das Herstellungsverfahren nach einem der vorangehenden Ansprüche erhalten wird.

**4.** Vorrichtung nach Anspruch 3, **dadurch gekennzeichnet, dass** das Substrat (1) aus Cycloolefin-Copolymer ausgeführt ist.

**5.** Vorrichtung nach Anspruch 3 oder 4, **dadurch gekennzeichnet, dass** das Bauteil (2) auf einem Silizium- oder Glassubstrat ausgeführt ist.

**6.** Vorrichtung nach Anspruch 5, **dadurch gekennzeichnet, dass** die Verankerungsnoppen zumindest einen ersten Verankerungsstift (240) aufweisen, der zumindest teilweise aus einem metallischen Material ausgeführt ist.

**7.** Vorrichtung nach Anspruch 6, **dadurch gekennzeichnet, dass** das Substrat (1) einen ersten Stromkreis aufweist und dass das Bauteil einen zweiten Stromkreis aufweist, wobei der erste Verankerungsstift (240) dazu ausgelegt ist, eine elektrische Verbindung zwischen dem ersten Stromkreis und dem zweiten Stromkreis herzustellen.

8.  Vorrichtung nach Anspruch 6 oder 7, **dadurch gekennzeichnet, dass** das metallische Material aus Kupfer oder einer Legierung des Typs SnAg zusammengesetzt ist.

9.  Vorrichtung nach einem der Ansprüche 5 bis 8, **dadurch gekennzeichnet, dass** die Verankerungsnoppen (24) eine oder mehrere aus Silizium ausgeführte Verankerungsnoppen aufweisen.

10. Vorrichtung nach einem der Ansprüche 3 bis 9, **dadurch gekennzeichnet, dass** die Verankerungsnoppen (24) an ihrem freien Ende eine abgerundete Kuppel oder eine ebene Fläche aufweisen.

11. Vorrichtung nach einem der Ansprüche 3 bis 10, **dadurch gekennzeichnet, dass** das Substrat Löcher aufweist, die jeweils dazu ausgelegt sind, einen einzelnen Verankerungsstift (24) des Bauteils (2) aufzunehmen, wobei die Löcher so ausgeführt sind, dass sie das Eindrücken jedes Verankerungsstifts (24) des Bauteils ermöglichen.

12. Vorrichtung nach einem der Ansprüche 3 bis 11, **dadurch gekennzeichnet, dass** das Bauteil (2) mit einer Seite, der sogenannten unteren Seite, an der oberen Seite des Substrats anliegt und über die Verankerungsnoppen (24) an das Substrat (1) angesiegelt ist, und dass das Bauteil zum dichten Verschließen der Öffnung (12, 122) des ersten Fluidkreislaufs an die obere Seite des Substrats angesiegelt ist.

13. Vorrichtung nach Anspruch 12, **dadurch gekennzeichnet, dass** die Öffnung (122) des ersten Fluidkreislaufs die Form eines Kanals aufweist, der an seiner oberen Wand durch die untere Seite des Bauteils verschlossen wird.

14. Vorrichtung nach einem der Ansprüche 3 bis 11, **dadurch gekennzeichnet, dass** das Bauteil (2) einen zweiten mikrofluidischen Kreislauf aufweist und dass das Bauteil (2) auf dem Substrat (1) positioniert ist, um eine dichte Fluidverbindung zwischen dem ersten mikrofluidischen Kreislauf des Substrats (1) und dem zweiten mikrofluidischen Kreislauf des Bauteils (2) zu gewährleisten.

15. Vorrichtung nach Anspruch 14, **dadurch gekennzeichnet, dass** der zweite mikrofluidische Kreislauf des Bauteils (2) zumindest einen mikrofluidischen Kanal aufweist, um eine dichte Fluidverbindung zwischen zwei Öffnungen (12) des ersten Fluidkreislaufs zu gewährleisten.

16. Vorrichtung nach einem der Ansprüche 3 bis 15, **dadurch gekennzeichnet, dass** das Bauteil (2) außerdem zumindest eine Reihe von Verankerungsnoppen (24) aufweist, die so angeordnet sind, dass sie sich im Substrat verankern, und so positioniert sind, dass sie eine Umfangswulst bilden, um die Montage des Bauteils (2) am Substrat (1) zu sichern.

**Claims**

1.  Process for manufacturing a micro-fluidic device, said device comprising a substrate (1) made of thermoplastic polymer having a face called the upper face (10) and a first micro-fluidic circuit that comprises at least one aperture (12, 122) that opens onto said upper face (10), and a component (2) bearing pads (24) arranged to become anchored in said substrate (1) on the periphery of said aperture (12, 122), said process being **characterized in that** it comprises the following steps:

    - heating so that the anchoring pads (24) of the component (2) reach a temperature at least equal to the glass-transition temperature of the substrate (1);
    - fastening the component to the substrate (1) by embedding then anchoring its pads (24) in the substrate (1).

2.  Process according to Claim 1, **characterized in that** it comprises a prior step of creating holes in the substrate (1), these holes each being configured to receive one separate anchoring pad of the component (2), with a view to facilitating the embedment of each anchoring pad (24) of the component in the fastening step.

3.  Micro-fluidic device comprising a substrate (1) made of thermoplastic polymer having a face called the upper face (10) and a first micro-fluidic circuit that comprises at least one aperture (12, 122) that opens onto said upper face (10), and a component (2) bearing pads (24) arranged to become anchored in said substrate (1) on the periphery of said aperture (12, 122), **characterized in that** it is obtained using the manufacturing process such as defined in one of the preceding claims.

4.  Device according to Claim 3, **characterized in that** the substrate (1) is made of cyclic olefin copolymer.

5.  Device according to Claim 3 or 4, **characterized in that** the component (2) is produced on a silicon or glass substrate.

6.  Device according to Claim 5, **characterized in that** the anchoring pads comprise at least one first anchoring pad (240) made at least partially from metal.

7. Device according to Claim 6, **characterized in that** the substrate (1) comprises a first electrical circuit and **in that** the component comprises a second electrical circuit, said first anchoring pad (240) being configured to make an electrical connection between the first electrical circuit and the second electrical circuit.

8. Device according to Claim 6 or 7, **characterized in that** the metal is composed of copper or of an alloy of SnAg type.

9. Device according to one of Claims 5 to 8, **characterized in that** the anchoring pads (24) comprise one or more anchoring pads made of silicon.

10. Device according to one of Claims 3 to 9, **characterized in that** the anchoring pads (24) have at their free end a rounded dome or a planar face.

11. Device according to one of Claims 3 to 10, **characterized in that** the substrate comprises holes that are each configured to receive one separate anchoring pad (24) of the component (2), said holes being produced with a view to facilitating the embedment of each anchoring pad (24) of the component.

12. Device according to one of Claims 3 to 11, **characterized in that** the component (2) is applied, via a face called the lower face, against the upper face of the substrate and sealed to the substrate (1) by way of said anchoring pads (24), and **in that** the component is sealed in order to close the aperture (12, 122) of the first fluidic circuit in a seal-tight manner, on the upper face of the substrate.

13. Device according to Claim 12, **characterized in that** the aperture (122) of the first fluidic circuit takes the form of a channel the upper side of which is closed by the lower face of said component.

14. Device according to one of Claims 3 to 11, **characterized in that** the component (2) comprises a second micro-fluidic circuit and **in that** said component (2) is positioned on the substrate (1) in order to ensure a seal-tight fluidic link between the first micro-fluidic circuit of the substrate (1) and the second micro-fluidic circuit of the component (2).

15. Device according to Claim 14, **characterized in that** the second micro-fluidic circuit of the component (2) comprises at least one micro-fluidic channel arranged to ensure a seal-tight fluidic link between two apertures (12) of the first fluidic circuit.

16. Device according to one of Claims 3 to 15, **characterized in that** the component (2) also comprises at least one row of anchoring pads (24) arranged to anchor in said substrate and placed to form a peripheral bead for consolidating the attachment of the component (2) to the substrate (1).

**Fig. 1**

*Fig. 2A*

*Fig. 2B*

*Fig. 2C*

*Fig. 2D*

*Fig. 2E*

**Fig. 3**

| F1 | F2 | F3 |

**Fig. 4A**

12  120  1

**Fig. 4B**

1  12  121

**Fig. 5**

C1

12

2

24

1

C2

120  121

2

24

1

C3

122

2

24

1

**Fig. 6**

**RÉFÉRENCES CITÉES DANS LA DESCRIPTION**

**Documents brevets cités dans la description**

- WO 2011042422 A1
- DE 102016226198 A1